(19) Europäisches Patentamt

European Patent Office

Office européen des brevets

(11) **EP 0 646 296 B2**

(12) **NOUVEAU FASCICULE DE BREVET EUROPEEN**

(45) Date de publication et mention de la décision concernant l'opposition:
**16.06.2004   Bulletin 2004/25**

(45) Mention de la délivrance du brevet:
**22.01.1997   Bulletin 1997/04**

(21) Numéro de dépôt: **94909149.0**

(22) Date de dépôt: **04.03.1994**

(51) Int Cl.$^7$: **H03H 9/145**

(86) Numéro de dépôt international:
**PCT/FR1994/000240**

(87) Numéro de publication internationale:
**WO 1994/022217 (29.09.1994 Gazette 1994/22)**

(54) **TRANSDUCTEUR A ONDES DE SURFACE A REFLEXION ACOUSTIQUE DISTRIBUEE ET FILTRE COMPORTANT UN TEL TRANSDUCTEUR**

Wandler für Oberflächenwellen mit verteilter akustischer Reflektion und Filter mit solch einem Wandler

DISTRIBUTED ACOUSTIC REFLECTION SURFACE WAVE TRANSDUCER AND FILTER COMPRISING SAME

(84) Etats contractants désignés:
**CH DE DK GB LI SE**

(30) Priorité:  **19.03.1993  FR 9303205**

(43) Date de publication de la demande:
**05.04.1995   Bulletin 1995/14**

(73) Titulaire: **Thales
75008 Paris (FR)**

(72) Inventeurs:
- **SOLAL, Marc
  F-92402 Courbevoie Cédex (FR)**
- **VENTURA, Pascal
  F-92402 Courbevoie Cédex (FR)**
- **HODE, Jean-Michel
  F-92402 Courbevoie Cédex (FR)**

(74) Mandataire: **Desperrier, Jean-Louis et al
Thomson-CSF Propriété Intellectuelle,
13, Avenue du Président Salvador Allende
94117 Arcueil Cédex (FR)**

(56) Documents cités:
**EP-A2- 0 140 618          FR-A- 2 653 632**

- **PATENT ABSTRACTS OF JAPAN vol. 015, no. 323 (E-1101) 16 Août 1991 & JP,A,03 119 815 (YAMANOUCHI) 22 Mai 1991**
- **P.V. Wright, S.A. Wilkus, "A Prototype low-loss Filter employing Single-phase unidirectional Transducers", Proc. of the Ultrasonics Symposium 1983, pages 72-75;**
- **C. Scholl et al., "New Resonator Filter with high Sidelobe Suppression", Proc. of the Ultrasonics Symposium 1992, pages 117-121;**
- **C.S. Hartmann, B.P. Abbott, "Overview of Design Challenges for Single-phase unidirectional SAW Filters", Proc. of the Ultrasonics Symposium 1989, pages 79-88;**
- **P. Ventura et al.; Synthesis of SPUDT Filters with simultaneous Reflection and Transduction Optimization", Proc. of the Ultrasonics Symposium 1992, pages 71-75.**
- **T. Kodama et al.,"Design of low-los SAW filters employing distributed acoustic reflection transducers", 1986 IEEE Ultrasonics Symposium Proceedings, pages 59-64**

EP 0 646 296 B2

## Description

L'invention concerne un transducteur à ondes de surface à réflexion acoustique distribuée et un filtre comportant un tel transducteur.

Des transducteurs et filtres de ce type sont d'un usage courant dans de nombreux domaines tels que les radars ou systèmes de radiocommunication mobile par exemple pour le filtrage de fréquence intermédiaire.

On connaît la réalisation de filtres à ondes de surface de type à cavités résonnantes à deux pôles comportant une voie acoustique dont les transducteurs bidirectionnels sont séparés par un réseau central réfléchissant.

Selon une variante de réalisation, il est également connu un agencement en parallèle de pareilles voies acoustiques où les transducteurs sont décalés d'une voie à l'autre de telle manière que la somme vectorielle des ondes en trajet direct s'annule.

Enfin, une troisième variante est l'utilisation de transducteurs à réflexion acoustique distribuée connus également sous l'appellation anglosaxonne DART de "Distributed Acoustic Reflexion Transducers", à la place des transducteurs classiques. Par la juxtaposition de cellules émettrices et réflectrices, ces transducteurs émettent la plus grande partie de leur énergie dans une direction privilégiée, ce qui permet d'obtenir des pertes faibles. Il est ainsi réalisé des transducteurs utilisant des cellules de type EWC, appellation anglosaxonne de "Electrode Width Control", des cellules réflectrices à deux réflecteurs de largeur $\lambda/4$ par longueur d'onde où $\lambda$ est la longueur d'onde correspondant à la fréquence centrale de fonctionnement du transducteur ou des cellules émettrices à trois électrodes de largeur $\lambda/6$ par longueur d'onde telles qu'elles sont décrites par exemple dans la demande de brevet français n° 2 653 632 déposée par la Demanderesse. Les cellules de transduction et d'émission dans ce type de transducteur sont disposées de manière à obtenir cohérence de phase entre les ondes émises dans la direction privilégiée de propagation et les ondes se propageant dans cette même direction après réflexion.

Les filtres à cavités résonnantes n'autorisent que de faibles bandes passantes relatives. Les deux autres types de réalisation ne permettent pas d'optimiser la taille du filtre,

- que ce soit en longueur à cause de la taille des transducteurs nécessaire pour réaliser le filtrage,
- que ce soit en largeur lorsque plusieurs voies acoustiques sont accolées pour améliorer les performances du filtre.

D'autre part, la multiplication des voies acoustiques mises en parallèle rend plus complexe la fabrication de tels composants.

Le but de l'invention est de pallier les inconvénients précités.

A cet effet, l'invention a pour objet un transducteur à ondes de surface à réflexion acoustique distribuée du type DART comprenant une juxtaposition de cellules émettrices et de cellules réflectrices caractérisé en ce qu'il comporte :

- au moins un changement de signe de la fonction de réflexion, c'est-à-dire qu'il comporte au moins un réflecteur dont le centre est distant de $k\lambda/2 + \lambda/4$ du centre des autres réflecteurs définissant ainsi une cellule à réflexion négative (- R), $\lambda$ étant la longueur d'onde correspondant à la fréquence centrale de fonctionnement du transducteur et k un entier non nul ;
- des zones (11,13) de cellules à réflexion positive, désignées par E, R, chacune de ces cellules comportant au moins une source (E) et un réflecteur (R) tels que les ondes émises par une source (E), dans une direction privilégiée X et les ondes réfléchies par un réflecteur (R) dans ladite direction, sont en phase à la fréquence centrale de fonctionnement du transducteur ;
- des zones (12) de cellules à réflexion négative comportant des cellules réflectrices (- R) telles que ci-dessus définies et dans lesquelles les ondes réfléchies sont en opposition de phase par rapport aux ondes émises ou réfléchies par les cellules à réflexion positive, dans la direction privilégiée x de propagation de l'onde, à la fréquence centrale de fonctionnement du transducteur,

la répartition spatiale adaptée des cellules à réflexion positive et des cellules à réflexion négative permettant de créer l'équivalent de petites cavités résonnantes à l'intérieur d'un même DART.

La répartition spatiale adaptée, dans la réalisation des DART, des cellules à réflexion positive et des cellules à réflexion négative selon l'invention permet la réalisation de filtres de type à cavités résonnantes formés de 2 DART ; en augmentant le nombre de trajets repliés le long de l'axe de propagation, on crée l'équivalent de petites cavités résonnantes à l'intérieur même d'un DART.

Les avantages de l'invention concernent essentiellement les dimensions du composant et son coût de réalisation. Les filtres selon l'invention donnent, avec une taille plus réduite, des performances équivalentes sinon meilleures à celles d'un filtre selon l'art antérieur. Leur réalisation est plus simple du fait que la mise en parallèle de voies acoustiques n'est pas nécessaire.

A titre d'exemple, il est possible de réaliser des filtres selon l'invention dont la longueur est inférieure de 20 à 30 % et dont les pertes d'insertion sont inférieures de 15 % et les variations du temps de propagation de groupes réduits de moitié par rapport à un filtre de même caractéristique selon l'art antérieur.

L'invention sera bien comprise et ses avantages et autres caractéristiques ressortiront lors de la description suivante de quelques exemples non limitatifs de réalisation en référence aux dessins schématiques annexés, dans lesquels :

- les figures 1 et 2 sont des vues en coupe d'une cellule de type EWC selon l'art antérieur,
- les figures 3, 4, 5 sont des vues en coupe de cellules pour la réalisation de DART ou filtres selon l'invention,
- les figures 6 et 7 représentent la réalisation d'autres cellules selon l'invention par juxtaposition de cellules de type précédent à des cellules réflectrices de longueur $\lambda/2$,
- les figures 8 et 9 sont une variante de réalisation des 2 cellules précédentes,
- la figure 10 représente un exemple de répartition des cellules de l'art antérieur et de l'invention dans la réalisation d'un DART,
- la figure 11 trace l'évolution du coefficient de réflexion de ce DART le long de l'axe de propagation des ondes,
- les figures 12 et 13 tracent les fonctions de transfert d'un filtre selon l'art antérieur et d'un filtre selon l'invention.

Les figures 14 à 16 représentent la réalisation de zones de transition utilisant des cellules émettrices à trois électrodes par longueur d'onde.

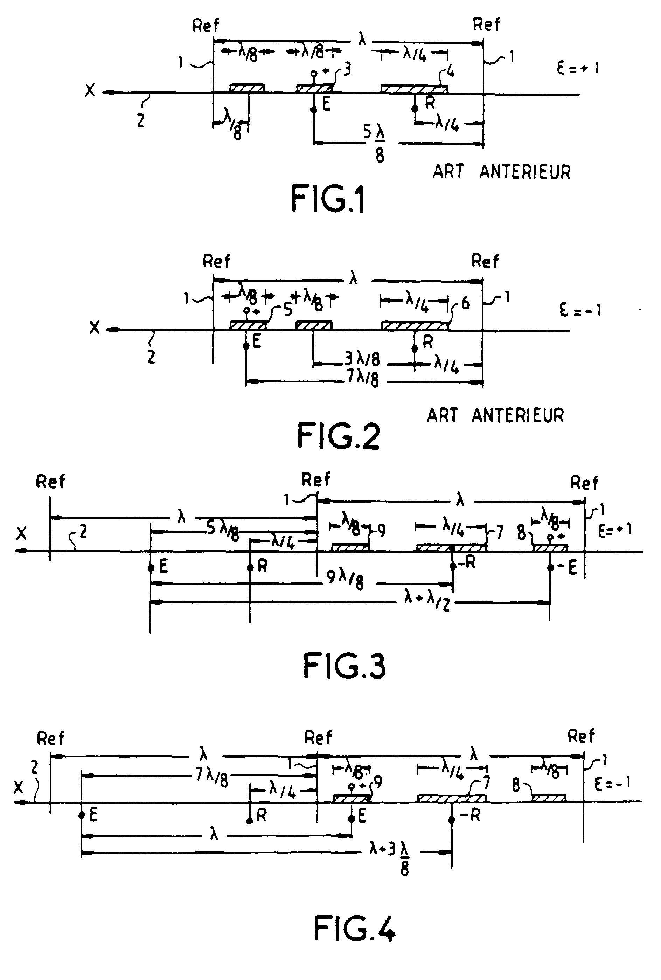

En se reportant aux figures 1 et 2, sur lesquelles, comme sur les figures suivantes, les éléments homologues sont repérés avec les mêmes références, il s'agit de cellules selon l'art antérieur connues sous le nom EWC comportant chacune un réflecteur et une source. Les frontières ou références 1 de ces cellules de longueur $\lambda$, qui sont conventionnelles et n'ont donc pas de réalité physique, ont été ici positionnées de manière à ce qu'elles correspondent aux références choisies pour les nouvelles cellules selon l'invention.

La direction de propagation privilégiée de l'onde acoustique dans un DART utilisant ce type de cellules est la direction de l'axe X. e définit le signe de la différence de marche $\lambda/4$ des ondes réfléchies sur un réflecteur et dépend des propriétés physiques des matériaux composant le filtre. La figure 1 décrit une cellule de type EWC dans le cas où e = + 1 selon laquelle la réflexion se fait avec une différence de marche de + $\lambda/4$ et la figure 2 une cellule dans le cas où e = - 1 selon laquelle la réflexion se fait avec une différence de marche de - $\lambda/4$.

Les ondes émises et réfléchies dans la direction de propagation privilégiée X sont en phase et les cellules sont dites à réflexion positive. Les références de phase des transducteurs 3 et 5 et des réflecteurs 4 et 6 sont repérées respectivement par les lettres E et R.

Ces références sont rappelées sur la figure 3 qui représente une cellule selon l'invention pour un filtre dont les matériaux correspondent a un coefficient e = + 1. Cette cellule de longueur $\lambda$ possède une électrode réflectrice 7 de largeur $\lambda/4$ en son centre et deux électrodes 8 et 9 de largeur $\lambda/8$ dont les centres sont distants de $3\lambda/8$ du centre de l'électrode réflectrice 7 et dont l'électrode de droite 8 est reliée au point chaud.

Les ondes renvoyées par le réflecteur 7 dans la direction X sont en opposition de phase par rapport aux ondes émises ou réfléchies dans cette direction privilégiée X par les cellules émettrices ou réflectrices de type connu du même substrat puisque la différence de marche par rapport aux ondes émises dans la direction X par un centre de transduction E est de

$$9\lambda/8 + \lambda/4 + 9\lambda/8 + k\lambda = \lambda/2 + k'\lambda$$

L'électrode au point chaud 8 émet les ondes dans la direction privilégiée X en opposition de phase par rapport aux transducteurs de cellules émettrices de type connu, son centre étant distant de $k\lambda + \lambda/2$ d'un centre de transduction E.

L'électrode de gauche 9 permet d'annuler la réflexion sur l'électrode 8 et, d'autre part, participe à la source dans le cas où l'on accole à la cellule une électrode chaude.

La cellule est ainsi appelée -R -E, à rapprocher de l'appellation E R de la cellule EWC représentée en figure 1 et est dite à réflexion négative du fait que les ondes réfléchies par le réflecteur de cette cellule sont en opposition de phase par rapport aux ondes émises ou réfléchies par les cellules à réflexion positive de l'art antérieur dans la direction privilégiée X de propagation de l'onde.

La figure 4 décrit une réalisation de cellule selon l'invention lorsque les matériaux utilisés pour le filtre correspondent à un coefficient $\varepsilon$=-1.

Dans ce cas, l'électrode de gauche 9 et non plus celle de droite 8 est reliée au point chaud permettant ainsi d'émettre les ondes en phase avec les ondes transmises dans la direction privilégiée X par les cellules à réflexion positive de l'art antérieur. Cette cellule à réflexion négative, puisque la différence de marche entre les ondes réfléchies dans la direction X et celles émises par un centre de transduction E dans cette même direction est de $3\lambda/8 - \lambda/4 + 3\lambda/8 + k\lambda = \lambda/2 + k\lambda$, est appelée E -R.

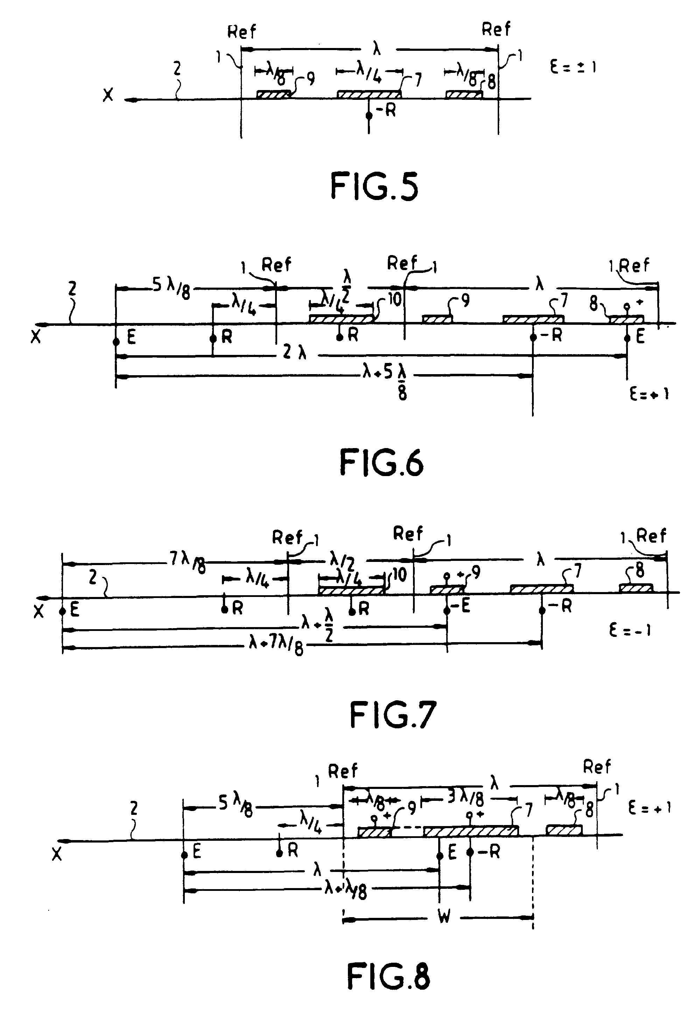

La figure 5 représente également une cellule à réflexion négative appelée -R puisque ne possédant pas de transducteur et pouvant être utilisée quel que soit le type de matériaux constituant le filtre. L'électrode de réflexion 7 de largeur $\lambda/4$ est placée au centre de la cellule, les 2 électrodes 8 et 9 de largeur $\lambda/8$ dont les centres sont distants de $3\lambda/8$ du centre de la cellule participent aux sources, dans le cas où les électrodes chaudes sont accolées à la cellule, se compensent quant à leur réflexion et permettent de conserver un rapport de métallisation à peu près constant voisin par exemple de 1/2.

D'une manière générale, les cellules selon l'invention, dites à réflexion négative, sont caractérisées par le fait que, l'axe de propagation X étant orienté positivement dans le sens de déplacement de l'onde résultante tel que représenté sur les figures, la distance algébrique entre la position $x_E$ du centre de transduction E de cellules émettrices selon l'art connu et la position $x_{-R}$ du centre de réflexion -R de ces nouvelles cellules est :

$$d = x_E - x_{-R} = 3\lambda/8 + \lambda/4 \pm k\ \lambda/2 \text{ pour } \varepsilon = +1$$

$$d = x_E - x_{-R} = 5\lambda/8 + \lambda/4 \pm k\ \lambda/2 \text{ pour } \varepsilon = -1$$

Selon la variante d'exécution de l'invention de la figure 6, l'interposition d'une cellule de longueur $\lambda/2$ en aval de cellules de longueur $\lambda$ si l'on considère le sens de déplacement privilégié des ondes dans le DART permet, tout en conservant ses caractéristiques de réflexion, d'inverser le signe de transduction de ces cellules comme il est expliqué ci-après.

La figure 6 montre, dans le cas $\varepsilon = +1$, la juxtaposition sur un substrat 2 et en aval de la cellule -R -E telle que décrite à la figure 3, d'une cellule nouvelle appelée cellule élémentaire réflectrice, de largeur $\lambda/2$ et possédant une électrode de réflexion 10 de largeur $\lambda/4$ en son centre. La cellule de largeur $\lambda$ a, de ce fait, l'électrode 8 reliée au point chaud qui émet en phase avec un centre de transduction E placé en aval puisque distant de $2\lambda + k\lambda$, et son réflecteur 7 qui réfléchit les ondes en opposition de phase puisque la différence de marche avec les ondes émises dans la direction de propagation privilégiée X est de $5\lambda/8 + 5\lambda/8 + \lambda/4 = \lambda/2 + k\lambda$. L'adjonction de la cellule nouvelle de largeur $\lambda/2$ pouvant comporter une électrode réflectrice en son centre en aval de la cellule de type -R -E donne ainsi une nouvelle cellule à réflexion négative de type -R E. Une deuxième cellule élémentaire de largeur $\lambda/2$ devra être placée en amont, toujours en considérant le sens de déplacement privilégié des ondes, si l'on désire rétablir les phases des transducteurs des cellules émettrices placées en amont.

La figure 7 montre la même réalisation lorsque les matériaux du filtre correspondent à $\varepsilon = -1$. La cellule élémentaire de largeur $\lambda/2$ pouvant comporter une électrode réflectrice 10 en son centre, placée en aval de la cellule E -R représentée sur la figure 4, permet de transformer cette cellule en une cellule de type -E -R.

Une variante aux cellules précédemment décrites consiste à remplacer les réflecteurs de largeur $\frac{\lambda}{4}$ des réflecteurs de largeur $\frac{3\lambda}{8}$. Cette largeur d'électrode permet lorsque l'épaisseur de métallisation est suffisamment importante ($h/\lambda \geq 1,5$ % où h est l'épaisseur de métallisation et $\lambda$ la longueur d'onde à la fréquence centrale) d'obtenir une amplitude de coefficient de réflexion plus importante qu'une électrode de largeur $\lambda/4$.

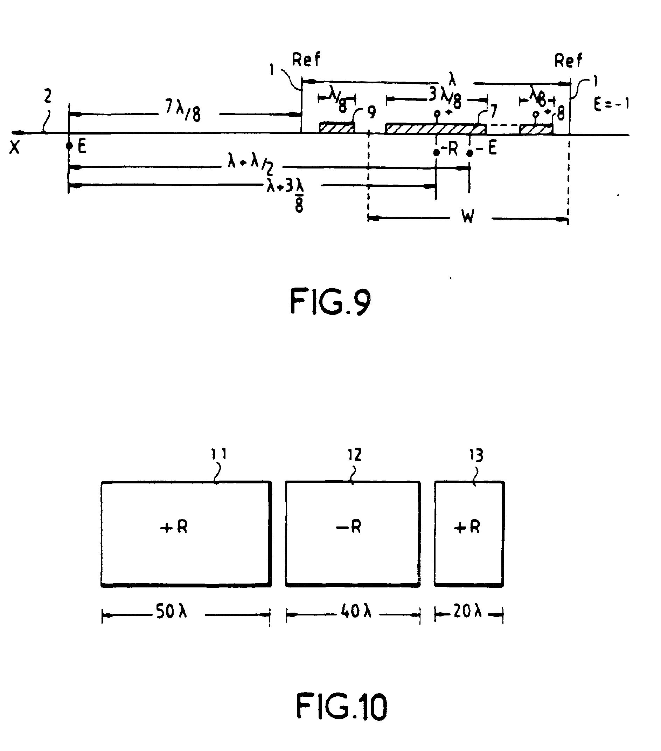

L'utilisation de cellules adjacentes de type cellules élémentaires pour la réalisation de cellules -R E lorsque $\varepsilon = +1$ et de cellules -E -R lorsque $\varepsilon = -1$ peut être évitée par l'emploi de nouvelles cellules. La figure 8 représente cette nouvelle cellule de longueur $\lambda$ lorsque $\varepsilon = +1$. Cette cellule se différencie de celles précédemment décrites en ce que l'électrode centrale 7 a une largeur de 3 $\lambda/8$ et est reliée au point chaud. Elle est flanquée de 2 électrodes 8 et 9 de largeur $\lambda/8$, leurs centres étant distants de 3 $\lambda/8$ du centre de la cellule, l'électrode de gauche 9 étant reliée également au point chaud.

L'ensemble des deux électrodes 7 et 9 reliées au point chaud se comporte électriquement approximativement comme une électrode unique de largeur $\frac{5\lambda}{8}$. Le centre de transduction de cette électrode unique est en son centre. Cette position correspond à celle des sources de type E. Acoustiquement, les réflexions des deux électrodes externes 8 et 9 de la cellule s'annulent puisque leurs centres sont distants de et $\frac{3\lambda}{4}$ et il ne reste plus que la réflexion sur l'électrode réflectrice 7 qui est distante de d'un $\frac{3\lambda}{4}$ centre de réflexion R. C'est donc une cellule E -R.

L'efficacité de la source est proportionnelle à

$$\sin\left(\frac{\pi W}{\lambda}\right)$$

où W est la distance entre les centres des espaces inter électrodes. On a ici par construction $W = \frac{3\lambda}{4}$ pour des cellules en aval selon l'invention, hypothèse de la figure 8.

L'efficacité à la fréquence centrale est donc proportionnelle à :

$$\sin\left[\frac{3\pi}{4}\right] = \frac{\sqrt{2}}{2}$$

Pour les autres cellules, l'espace W est $W = \frac{\lambda}{4}$ et l'efficacité est proportionnelle à :

$$\sin\left[\frac{\pi}{4}\right] = \frac{\sqrt{2}}{2}$$

L'efficacité de la source pour la cellule E -R est donc, au premier ordre, la même que celle des autres sources.

Pour des matériaux donnant un coefficient $\varepsilon$ négatif, comme représenté sur la figure 9, c'est l'électrode de droite 8 et non plus l'électrode de gauche 9 qui, en même temps que l'électrode centrale 7 de largeur 3 $\lambda$/8, est reliée au point chaud.

La cellule à réflexion négative est du type -R -E.

Un décalage d'électrode de $\frac{\lambda}{48}$ pourra avantageusement être utilisé chaque fois que l'électrode chaude d'une cellule telle que décrite précédemment est entourée de deux espaces non égaux, ce qui est en général le cas lorsque l'on utilise des réflecteurs de largeur $\lambda$/4.

Les filtres selon l'invention utilisent des transducteurs de type DART comportant, pour au moins l'un d'entre eux, au moins une cellule à réflexion négative.

La répartition et dimension des zones comportant des cellules à réflexion positive selon l'art antérieur et des zones comportant des cellules à réflexion négative ainsi que le choix des cellules composant ces zones permet d'obtenir la fonction de transfert se rapprochant le plus de celle désirée pour une taille du filtre minimum. Les transitions de zones correspondant à un changement de signe du coefficient de réflexion. La figure 10 est un exemple de réalisation d'un DART utilisé dans un filtre selon l'invention.

Sa longueur est d'environ 110 $\lambda$ et il se compose de 3 zones :

- une zone 11 d'environ 50 $\lambda$ comportant des cellules à réflexion positive,
- une zone 12 d'environ 40 $\lambda$ comportant des cellules à réflexion négative,
- une zone 13 d'environ 20 $\lambda$ comportant des cellules à réflexion positive.

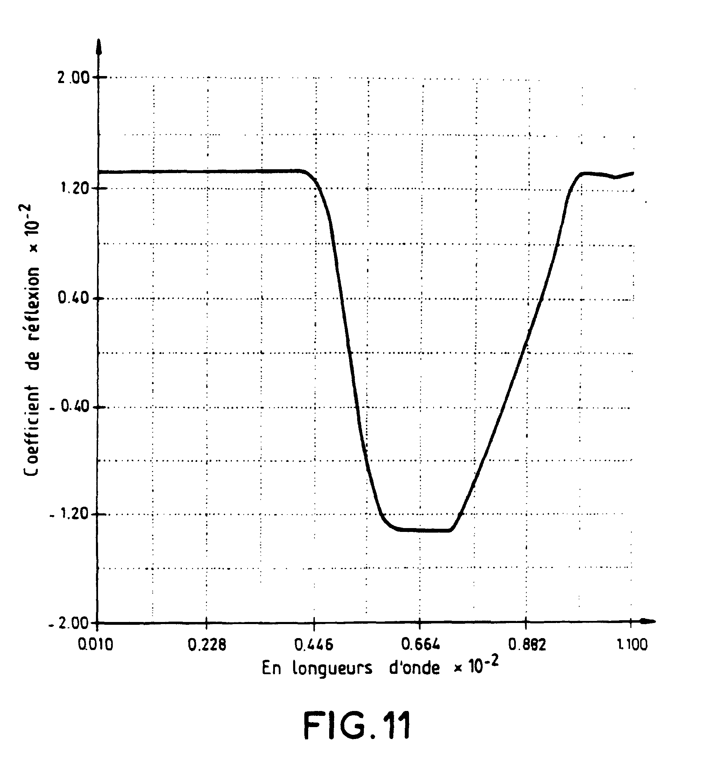

La figure 11 montre l'évolution du coefficient de réflexion du DART tel que schématisé à la figure 10 le long de l'axe de propagation des ondes.

L'axe des abscisses représente l'axe de propagation de l'onde dans le DART ; il est gradué en centaines de longueur d'onde. L'axe des ordonnées correspond au coefficient de réflexion des ondes et est gradué en centièmes. Le changement de signe de ce coefficient a lieu aux environs de 50 $\lambda$ et de 90 $\lambda$ : transitions de zones.

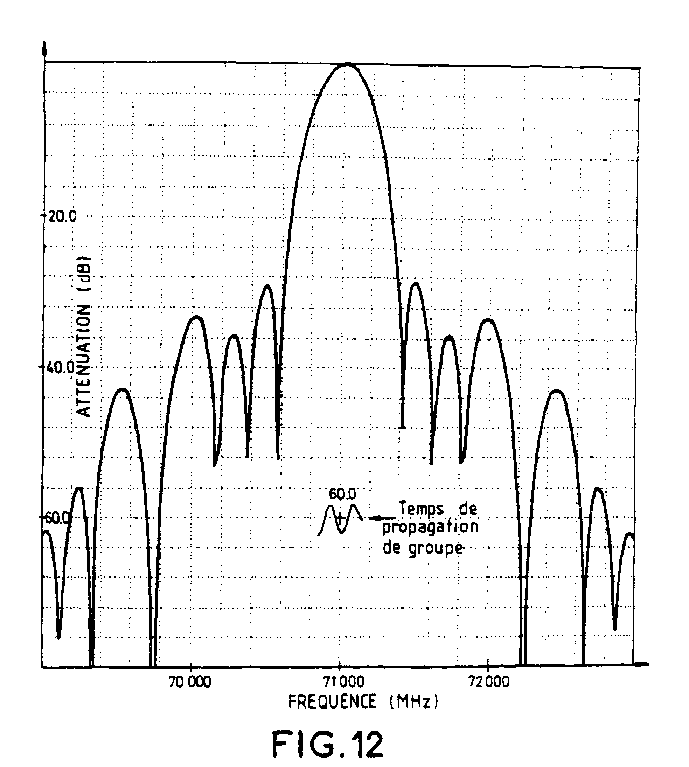

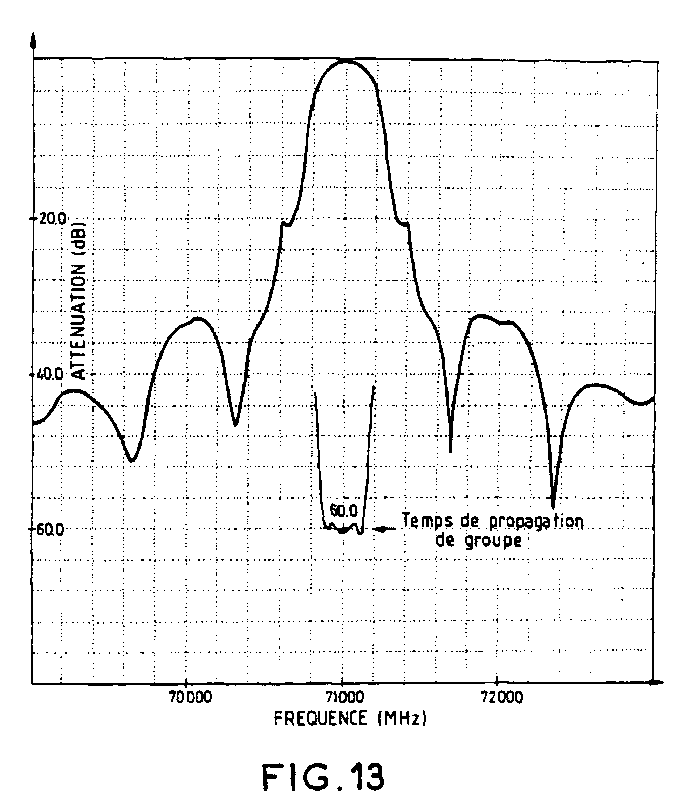

Les courbes des figures 12 et 13 donnent respectivement les tracés obtenus par simulation de la fonction de transfert d'un filtre de longueur utile 15 mm et sans cellules à réflexion négative et d'un filtre de longueur utile 11 mm avec cellules à réflexion négative.

L'atténuation du filtre, reportée sur l'axe des ordonnées en décibels est donnée en fonction de la fréquence du signal exprimée en Mégahertz sur l'axe des abscisses.

La fréquence centrale de fonctionnement des filtres est 71 MHz.

Les améliorations des caractéristiques techniques concernent essentiellement les pertes d'insertion qui passent de 7,4 dB pour le filtre selon l'art antérieur à 6,5 dB pour le filtre selon l'invention (non représentées sur les figures), la variation du temps de propagation de groupe qui passe de 200 ns à 100 ns pour le filtre selon l'invention, la diminution du niveau des lobes secondaires et l'augmentation de la bande passante.

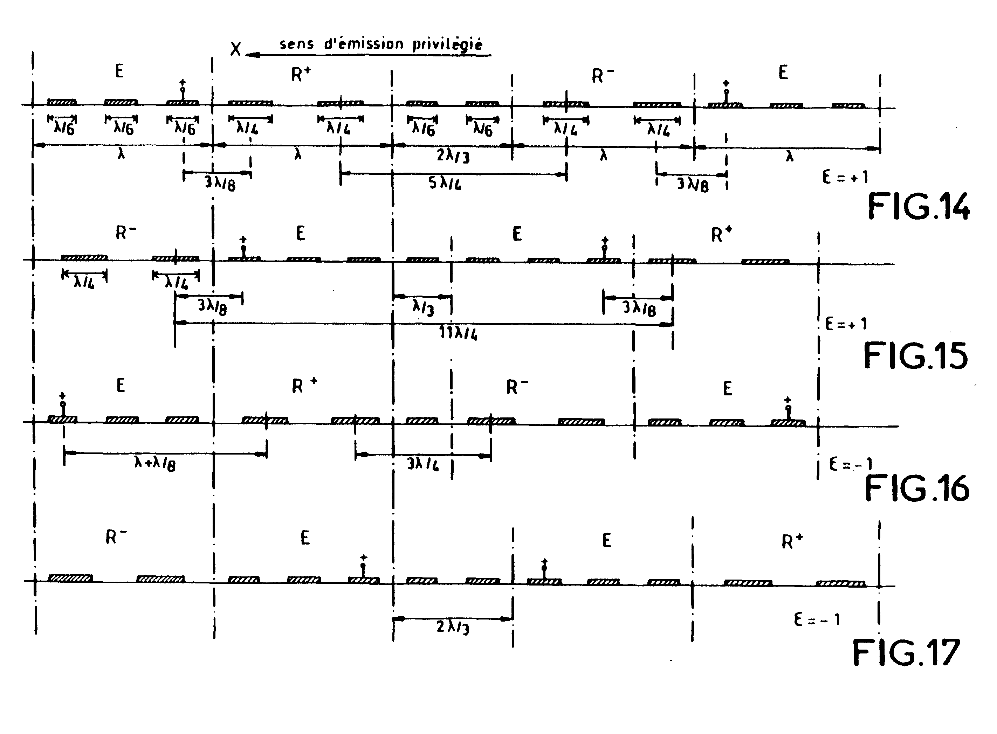

Dans le cas des cellules émettrices comportant trois électrodes de largeur $\lambda$/6 par longueur d'onde et de cellules réflectrices comportant deux réflecteurs de largeur $\lambda$/4 par longueur d'onde, on associe, selon une autre forme de réalisation de l'invention, les cellules E et R pour constituer les transitions de zones telles que représentées sur les figures 14, 15, 16 et 17 qui correspondent aux quatre cas possibles.

Sur la figure 14 la transition ER +, ER - pour $\varepsilon$ = + 1 est obtenue par une cellule de largeur 2$\lambda$/3 comportant deux électrodes de largeur $\lambda$/6 placées symétriquement.

Sur la figure 15 la transition ER -, ER + pour $\varepsilon$ = + 1 est obtenue par une cellule de largeur $\lambda$/3 comportant en son centre une électrode de largeur $\lambda$/6.

Sur les figures 16 et 17, les transitions ER +, ER - et ER -, ER + pour $\varepsilon$ = - 1 sont obtenues à l'inverse de précédemment.

**Revendications**

1. Transducteur à ondes de surface à réflexion acoustique distribuée du type DART comprenant une juxtaposition de cellules émettrices et de cellules réflectrices **caractérisé en ce qu'**il comporte :

   - au moins un changement de signe de la fonction de réflexion, c'est-à-dire qu'il comporte au moins un réflecteur dont le centre est distant de k$\lambda$/2 + $\lambda$/4 du centre des autres réflecteurs définissant ainsi une cellule à réflexion négative (- R), $\lambda$ étant la longueur d'onde correspondant à la fréquence centrale de fonctionnement du transducteur et k un entier non nul ;
   - des zones (11,13) de cellules à réflexion positive, désignées par E, R, chacune de ces cellules comportant au moins une source (E) et un réflecteur (R) tels que les ondes émises par une source (E), dans une direction privilégiée X et les ondes réfléchies par un réflecteur (R) dans ladite direction, sont en phase à la fréquence centrale de fonctionnement du transducteur ;
   - des zones (12) de cellules à réflexion négative comportant des cellules réflectrices (- R) telles que ci-dessus définies et dans lesquelles les ondes réfléchies sont en opposition de phase par rapport aux ondes émises ou réfléchies par les cellules à réflexion positive, dans la direction privilégiée X de propagation de l'onde, à la fréquence centrale de fonctionnement du transducteur,

   la répartition spatiale adaptée des cellules à réflexion positive et des cellules à réflexion négative permettant de créer l'équivalent de petites cavités résonantes à l'intérieur d'un même DART.

2. Transducteur selon la revendication 1, **caractérisé en ce qu'**une ou plusieurs cellules à réflexion négative (7, 8, 9), de longueur la longueur d'onde $\lambda$ correspondant à la fréquence centrale de fonctionnement du transducteur, possède une électrode de réflexion (7) placée en son centre dont la largeur est égale au quart de la longueur d'onde $\lambda$.

3. Transducteur selon la revendication 1, **caractérisé en ce qu'**une ou plusieurs cellules à réflexion négative (7, 8, 9), de longueur la longueur d'onde $\lambda$ correspondant à la fréquence centrale de fonctionnement du transducteur, possède une électrode de réflexion (7) placée en son centre dont la largeur est égale aux trois huitièmes de la longueur d'onde $\lambda$.

4. Transducteur selon la revendication 1, **caractérisé en ce qu'**au moins une cellule à réflexion négative (7, 8, 9), de longueur la longueur d'onde $\lambda$ correspondant à la fréquence centrale de fonctionnement du transducteur, est constituée d'une électrode centrale (7) de largeur les trois huitièmes de la longueur d'onde $\lambda$ reliée au point chaud, flanquée de 2 électrodes (8, 9) de largeur un huitième de la longueur d'onde $\lambda$, dont leur centre est distant du centre de la cellule (7, 8, 9) de trois huitièmes de la longueur d'onde et dont l'une des deux (8, 9) est également reliée au point chaud.

5. Transducteur selon la revendication 1, **caractérisé en ce qu'**il comprend, en aval d'au moins une cellule à réflexion négative (7, 8, 9) en considérant la direction de propagation X de l'onde résultante dans le DART, une cellule élémentaire (10) de longueur une demi longueur d'onde $\lambda$ correspondant à la fréquence centrale de fonctionnement du transducteur et pouvant posséder en son centre une électrode de réflexion (10) de largeur.

6. Transducteur selon les revendications 1 à 5, **caractérisé en ce qu'**il comprend des cellules émettrices, de longueur la longueur d'onde $\lambda$, comportant trois électrodes de largeur $\lambda/6$ espacées de $\lambda/3$ et de cellules réflectrices, de longueur la longueur d'onde $\lambda$, comportant deux électrodes de largeur $\lambda/4$ espacées de $\lambda/2$ et **en ce que** deux cellules réflectrices ou deux cellules émettrices sont espacées de $\lambda/3$ ou $2\lambda/3$.

7. Filtre à ondes de surface, **caractérisé en ce qu'**il comporte au moins un transducteur selon l'une quelconque des revendications 1 à 6.

**Patentansprüche**

1. Oberflächenwellenwandler mit verteilter akustischer Reflektion des DART-Typs mit einer Nebeneinandersetzung von emittierenden Zellen und reflektierenden Zellen, **dadurch gekennzeichnet, dass** er folgendes umfasst:

   - zumindest einen Vorzeichenwechsel der Reflektionsfunktion, das heißt er umfasst zumindest einen Reflektor, dessen Mitte um $k\lambda/2 + \lambda/4$ von der Mitte der anderen Reflektoren beabstandet ist, wodurch eine Zelle mit negativer Reflektion (-R) definiert wird, wobei $\lambda$ die der Betriebsmittenfrequenz des Wandlers entsprechende Wellenlänge und k eine von Null verschiedene ganz Zahl ist,
   - Bereiche (11, 13) von Zellen mit positiver Reflektion, die mit E, R bezeichnet sind,

   wobei jede dieser Zellen zumindest eine Quelle (E) und einen Reflektor (R) umfasst, so dass die von einer Quelle (E) in eine bevorzugte Richtung X emittierten Wellen und die durch einen Reflektor (R) in die Richtung reflektierten Wellen bei der Betriebsmittenfrequenz des Wandlers in Phase sind,

   - Bereiche (12) von Zellen mit negativer Reflektion, die Reflektionszellen (-R) umfassen, wie sie oben definiert sind, und in denen die reflektierten Wellen relativ zu den durch die Zellen mit positiver Reflektion emittierten oder reflektierten Wellen in der bevorzugten Richtung X und bei der Betriebsmittenfrequenz des Wandlers gegenphasig sind,

   wobei die angepasste räumliche Verteilung der Zellen mit positiver Reflektion und der Zellen mit negativer Reflektion es gestattet, das Äquivalent von kleinen Resonanzhohlräumen im Inneren ein und desselben DART zu erzeugen.

2. Wandler nach Anspruch 1, **dadurch gekennzeichnet, daß** eine oder mehrere Zellen mit negativer Reflexion (7, 8, 9) von der Länge der der Betriebsmittenfrequenz des Wandlers entsprechenden Wellenlänge $\lambda$ eine in ihrer Mitte angeordnete Reflexionselektrode (7) besetzen, deren Breite gleich einem Viertel der Wellenlänge $\lambda$ ist.

3. Wandler nach Anspruch 1, **dadurch gekennzeichnet, daß** eine oder mehrere Zellen mit negativer Reflexion (7, 8, 9) von der Länge der der Betriebsmittenfrequenz des Wandlers entsprechenden Wellenlänge $\lambda$ eine in ihrer Mitte angeordnete Reflexionselektrode (7) besitzen, deren Breite gleich drei Achteln der Wellenlänge $\lambda$ ist.

**4.** Wandler nach Anspruch 1, **dadurch gekennzeichnet, daß** wenigstens eine Zelle mit negativer Reflexion (7, 8, 9) von der Länge der der Betriebsmittenfrequenz des Wandlers entsprechenden Wellenlänge λ durch eine zentrale Elektrode (7) mit einer Breite von drei Achteln der Wellenlänge λ gebildet ist, die mit dem heißen Punkt verbunden ist und von zwei Elektroden (8, 9) mit der Breite eines Achtels der Wellenlänge λ flankiert ist, deren Mitte von der Mitte der Zelle (7, 8, 9) einen Abstand von drei Achteln der Wellenlänge hat, und wovon eine der beiden Zellen (8, 9) ebenfalls mit dem heißen Punkt verbunden ist.

**5.** Wandler nach Anspruch 1 , **dadurch gekennzeichnet, daß** er, betrachtet in der Ausbreitungsrichtung X der im DART resultierenden Welle, vor wenigstens einer Zelle mit negativer Reflexion (7, 8, 9) eine Elementarzelle (10) von der Länge der Hälfte der der Betriebsmittenfrequenz des Wandlers entsprechenden Wellenlänge λ aufweist, die in ihrer Mitte eine Reflexionselektrode (10) der Breite haben kann.

**6.** Wandler nach den Ansprüchen 1 bis 5, **dadurch gekennzeichnet, daß** er Sendezellen von der Länge der Wellenlänge λ enthält, die drei Elektroden der Breite λ/6 im Abstand X/3 aufweisen, sowie Reflektorzellen von der Länge der Wellenlänge λ, die zwei Elektroden der Breite λ/4 im Abstand X/2 aufweisen, und daß zwei Reflektorzellen oder zwei Sendezellen den Abstand λ/3 oder 2λ/3 haben.

**7.** Oberflächenwellenfilter, **dadurch gekennzeichnet, daß** es wenigstens einen Wandler nach einem der Ansprüche 1 bis 6 enthält.

**Claims**

**1.** Distributed acoustic reflection surface wave transducer of the DART type comprising a juxtaposition of emitting cells and of reflecting cells, **characterized in that** it comprises:

- at least one change of sign of the reflection function, that is to say that it comprises at least one reflector whose centre is a distance kλ/2 + λ/4 from the centre of the other reflectors thus defining a cell with negative reflection (-R), λ being the wavelength corresponding to the central frequency of operation of the transducer and k a non-zero integer;
- zones (11, 13) of cells with positive reflection, denoted by E, R, each of these cells comprising at least one source (E) and one reflector (R) that are such that the waves emitted by a source (E), in a favoured direction X, and the waves reflected by a reflector (R) in the said direction are in phase at the central frequency of operation of the transducer;
- zones (12) of cells with negative reflection comprising reflecting cells (-R) such as above defined and in which the reflected waves are in phase opposition with respect to the waves emitted or reflected by the cells with positive reflection, in the favoured direction X of propagation of the wave, at the central frequency of operation of the transducer,

   the matched spatial layout of the cells with positive reflection and the cells with negative reflection making it possible to create the equivalent of small resonant cavities inside one and the same DART.

**2.** Transducer according to Claim 1, **characterized in that** one or more negative-reflection cells (7, 8, 9), of length the wavelength λ corresponding to the central operating frequency of the transducer, possesses a reflection electrode (7), placed at its centre, the width of which is equal to a quarter of the wavelength λ.

**3.** Transducer according to Claim 1, **characterized in that** one or more negative-reflection cells (7, 8, 9), of length the wavelength λ corresponding to the central operating frequency of the transducer, possesses a reflection electrode (7), placed at its centre, the width of which is equal to three eighths of the wavelength λ.

**4.** Transducer according to Claim 1, **characterized in that** at least one negative-reflection cell (7, 8, 9), of length the wavelength λ corresponding to the central operating frequency of the transducer, is formed by a central electrode (7) of width three eighths of the wavelength λ, connected to the live point, flanked by 2 electrodes (8, 9) of width one eighth of the wavelength λ, the centre of which is at a distance of three eighths of the wavelength from the centre of the cell (7, 8, 9) and one of the two electrodes (8, 9) of which is also connected to the live point.

**5.** Transducer according to Claim 1, **characterized in that** it comprises, downstream of at least one negative-reflection cell (7, 8, 9), referring to the direction of propagation X of the resultant wave in the DART, an elementary cell (10) of length one half the wavelength λ corresponding to the central operating frequency of the transducer and being able to possess, at its centre, a reflection electrode (10) of width [lacuna].

**6.** Transducer according to Claims 1 to 5, **character-**

**ized in that** it comprises emitting cells, of length the wavelength λ, which include three electrodes of width λ/6 spaced apart by λ/3 and reflecting cells, of length the wavelength λ, which include two electrodes of width λ/4 spaced apart by λ/2, and **in that** two reflecting cells or two emitting cells are spaced apart by λ/3 or 2λ/3.

7. Surface-wave filter, **characterized in that** it includes at least one transducer according to any one of Claims 1 to 6.

ART ANTERIEUR

# FIG.1

ART ANTERIEUR

# FIG.2

# FIG.3

# FIG.4

FIG.5

FIG.6

FIG.7

FIG.8

FIG.9

FIG.10

**FIG.11**

FIG.12

FIG.13

X ← sens d'émission privilégié

FIG.14

FIG.15

FIG.16

FIG.17

EP 0 646 296 B2